# EUROPÄISCHE PATENTSCHRIFT

(11) **EP 2 201 624 B1**
(45) Veröffentlichungstag und Bekanntmachung des Hinweises auf die Patenterteilung: **05.06.2019**
(21) Anmeldenummer: 08801135.8
(22) Anmeldetag: 04.08.2008
(51) Int. Cl.: H01L 51/50, H01L 51/52, H01L 27/32

(54) **OPTOELEKTRONISCHES BAUTEIL**
OPTO-ELECTRONIC COMPONENT
COMPOSANT OPTOÉLECTRONIQUE

(30) Priorität: 19.09.2007 DE 102007044597
(43) Veröffentlichungstag der Anmeldung: 30.06.2010
(73) Patentinhaber: OSRAM OLED GmbH, 93049 Regensburg (DE)
(72) Erfinder: KLEIN, Markus, 93105 Tegernheim (DE); VON MALM, Norwin, 93152 Nittendorf (DE); KRUMMACHER, Benjamin Claus, 93057 Regensburg (DE)
(74) Vertreter: Epping - Hermann - Fischer
(86) Internationale Anmeldenummer: PCT/DE2008/001302
(87) Internationale Veröffentlichungsnummer: WO 2009/036718

(56) Entgegenhaltungen:
- EP-A- 1 804 092
- WO-A-2007/051499
- US-A1- 2005 189 857

## Beschreibung

Die vorliegende Erfindung betrifft ein optoelektronisches Bauteil, das im Betrieb elektromagnetische Strahlung emittieren kann und im ausgeschalteten Zustand einen gewünschten Farbeindruck aufweist.

Die Druckschriften WO 2007/051499 A, US 2005/189857 A1 und EP-A-1 804 092 betreffen optoelektronische Bauteile.

Zumindest eine Aufgabe von bestimmten Ausführungsformen der vorliegenden Erfindung ist es daher, ein optoelektronisches Bauteil mit einer Wellenlängenkonversionsschicht anzugeben, das in einem ausgeschalteten Zustand einen unerwünschten Farbeindruck mindern oder vermeiden kann.

Diese Aufgabe wird durch den Gegenstand mit den Merkmalen des unabhängigen Patentanspruchs gelöst. Vorteilhafte Ausführungsformen und Weiterbildungen des Gegenstands sind in den abhängigen Ansprüchen gekennzeichnet und gehen aus der nachfolgenden Beschreibung und den Zeichnungen hervor.

Ein optoelektronisches Bauteil gemäß einer Ausführungsform der Erfindung umfasst insbesondere eine organische Schichtenfolge, die im Betrieb eine elektromagnetische Strahlung mit einem ersten Spektrum abstrahlt sowie eine strukturierte Schicht, die der organischen Schichtenfolge im Strahlengang der von der organischen Schichtenfolge abgestrahlten elektromagnetischen Strahlung nachgeordnet ist und erste und zweite Bereiche aufweist. Dabei weisen die ersten Bereiche jeweils eine Wellenlängenkonversionsschicht auf, die eingerichtet ist, zumindest teilweise elektromagnetische Strahlung mit dem ersten Wellenlängenspektrum in eine elektromagnetische Strahlung mit einem zweiten Wellenlängenspektrum umzuwandeln. Des Weiteren weisen die zweiten Bereiche jeweils eine Filterschicht auf, die für eine elektromagnetische Strahlung mit einem dritten Wellenlängenspektrum, das zumindest einem Teil des zweiten Wellenlängenspektrums entspricht, wenigstens teilweise undurchlässig ist.

Insbesondere kann dabei von einem Betrachter im Betrieb des optoelektronischen Bauteils eine emittierte elektromagnetische Strahlung wahrgenommen werden. Diese kann im Wesentlichen einer Überlagerung der elektromagnetischen Strahlung mit dem ersten Wellenlängenspektrum, welche durch die zweiten Bereiche abgestrahlt wird, und der elektromagnetischen Strahlung mit dem zweiten Wellenlängenspektrum, welche von der Wellenlängenkonversionsschicht der ersten Bereiche abgestrahlt wird, entsprechen.

Dabei wird im Betrieb des optoelektronischen Bauteils die elektromagnetische Strahlung mit dem ersten Wellenlängenspektrum von der organischen Schichtenfolge abgestrahlt und trifft auf die ersten und zweiten Bereiche der strukturierten Schicht. In den ersten Schichten wird die elektromagnetische Strahlung mit dem ersten Wellenlängenspektrum zumindest teilweise, in verschiedenen Ausführungsformen aber vollständig in elektromagnetische Strahlung mit dem zweiten Wellenlängenspektrum umgewandelt. Die jeweiligen Filterschichten in den zweiten Bereichen sind zwar für elektromagnetische Strahlung mit dem dritten Wellenlängenspektrum, das zumindest einem Teil des zweiten Wellenlängenspektrums entspricht, undurchlässig, aber durchlässig für elektromagnetische Strahlung mit dem ersten Wellenlängenspektrum. Im Gesamteindruck der von dem optoelektronischen Bauteil abgestrahlten elektromagnetischen Strahlung kommt es daher zu einer Überlagerung des ersten und zweiten Wellenlängenspektrums.

In wenigstens einer Ausführungsform ist die strukturierte Schicht physikalisch und/oder chemisch an die organische Schichtenfolge befestigt. Dies bedeutet insbesondere, dass die strukturierte Schicht beispielsweise mit einem transparenten Klebstoff, oder einem Gel, das bezüglich seines Brechungsindexes angepasst ist, auf die organische Schichtenfolge aufgebracht ist oder chemische, zum Beispiel kovalente Bindungen an die organische Schichtenfolge aufweist.

Die Struktur der strukturierten Schicht kann in verschiedenen Ausführungsformen der Erfindung gestreifte, gekreuzt gestreifte, also gitterartige, kreisförmige, dreiecksförmige oder rechteckige, also schachbrettartige Bereiche oder Bereiche einer beliebigen Geometrie als Kombination der oben genannten geometrischen Formen umfassen. Weiterhin kann die Struktur der strukturierten Schicht unregelmäßige Muster von Bereichen umfassen, insbesondere Muster, bei denen erste und zweite Bereiche variable Dimensionen und Formen aufweisen. Anders ausgedrückt wird ein Muster der strukturierten Schicht durch eine jeweilige spezielle Anordnung der ersten und zweiten Bereiche gebildet. Die Bereiche der strukturierten Schicht sind vorzugsweise lateral oder nebeneinander im Strahlengang des optoelektronischen Bauteils angeordnet. Das heißt, die Bereiche sind nicht übereinander gestapelt im Strahlengang angeordnet, sondern beispielsweise benachbart zueinander.

Die Dimensionen der Bereiche, beispielsweise die Auflösung der Bereiche der strukturierten Schicht, kann in der Größenordnung von kleiner als 1 mm sein, vorzugsweise in der Größenordnung von 100 pm bis einige 100 µm, und weiter bevorzugt in der Größenordnung von kleiner als 100 pm. Besonders für Lichtapplikationen, bei denen das optoelektronische Bauteil nicht in Kombination mit optischen Bildtechniken oder Geräten benutzt wird, kann es ausreichend sein, an die Dimensionen der Bereiche der strukturierten Schicht nur moderate Anforderungen zu stellen.

Bei einer weiteren Ausführungsform der Erfindung bezeichnet "Wellenlängenspektrum" oder "Spektrum" oder "Teilspektrum" eine spektrale Verteilung von elektromagnetischer Strahlung mit mindestens einer spektralen Komponente mit einer Wellenlänge oder einer Mehrzahl von spektralen Komponenten mit mehreren Wellenlängen und/oder Bereichen von Wellenlängen. Ein erstes Spektrum und ein zweites Spektrum sind im Folgenden gleich, wenn die spektralen Komponenten und deren relativen Intensitäten gleich im Falle des ersten und des zweiten Spektrums sind, wobei die absolute Intensität des ersten Spektrums von der absoluten Intensität des zweiten Spektrums abweichen kann.

Bei einer Ausführungsform der Erfindung bezeichnet "teilweise" ein Teilspektrum eines Spektrums, beispielsweise des ersten Spektrums. Insbesondere kann das Teilspektrum eines Spektrums aus einem Teil der spektralen Komponenten dieses Spektrums bestehen. Weiterhin kann "teilweise" auch einen Teil einer Intensität eines Spektrums oder Teilspektrums bezeichnen.

Bei einer weiteren Ausführungsform der Erfindung kann "umwandeln" bedeuten, dass das Teilspektrum der elektromagnetischen Strahlung mit dem ersten Spektrum, die von der Wellenlängenkonversionsschicht zumindest teilweise in elektromagnetische Strahlung mit dem zweiten Spektrum umgewandelt wird, und das zweite Spektrum nicht gleich sind. Das kann insbesondere bedeuten, dass das zweite Spektrum eine spektrale Verteilung aufweist, die von der spektralen Verteilung des Teilspektrums der elektromagnetischen Strahlung mit dem ersten Spektrum verschieden ist.

Weiterhin kann eine Wellenlängenkonversionsschicht ein Absorptionsspektrum und ein Emissionsspektrum aufweisen, wobei das Absorptionsspektrum und das Emissionsspektrum vorteilhafterweise nicht gleich sind. Vorzugsweise umfasst das Absorptionsspektrum dabei das Teilspektrum der elektromagnetischen Strahlung mit dem ersten Spektrum und das Emissionsspektrum das zweite Spektrum. Insbesondere können das Absorptionsspektrum und das Emissionsspektrum jeweils weitere spektrale Komponenten umfassen, die nicht im Teilspektrum der elektromagnetischen Strahlung mit dem ersten Spektrum beziehungsweise dem zweiten Spektrum enthalten sind.

Fällt nun elektromagnetische Strahlung mit einer bestimmten Wellenlänge von außen oder vom aktiven Bereich der Halbleiterschichtenfolge auf die Wellenlängenkonversionsschicht ein und weist das Absorptionsspektrum eine spektrale Komponente mit dieser bestimmten von der Wellenlängenkonversionsschicht absorbierbaren Wellenlänge auf, so wird die elektromagnetische Strahlung mit dieser bestimmten Wellenlänge in elektromagnetische Strahlung mit einer oder mehreren anderen, von besagter bestimmten Wellenlänge verschiedenen Wellenlängen, die im Emissionsspektrum enthalten sind, wieder abgestrahlt, also re-emittiert. Es wird also in der Wellenlängenkonversionsschicht aus elektromagnetischer Strahlung mit dem ersten Wellenlängenspektrum eine elektromagnetische Strahlung mit dem zweiten Wellenlängenspektrum erzeugt. Dadurch kann es insbesondere auch bei von außen auf das optoelektronische Bauteil einfallender Strahlung möglich sein, dass die Wellenlängenkonversionsschicht bei einem ausgeschalteten Zustand des optoelektronischen Bauteils bei einem Betrachter entsprechend ihrem Absorptionsspektrum und ihrem Emissionsspektrum durch von außen auf das optoelektronische Bauteil einfallende Strahlung, die reflektiert oder durch einen beschriebenen Absorptions- und Re-Emissionsvorgang abgestrahlt werden kann, einen Farbeindruck erwecken kann, der für sich genommen unerwünscht sein kann. Dieser Farbeindruck kann beispielsweise dadurch unerwünscht sein, als dass er verschieden vom Farbeindruck der im Betrieb des optoelektronischen Bauteils emittierten elektromagnetischen Strahlung sein kann.

Insofern kann die Filterschicht besonders vorteilhaft sein, als dass die Filterschicht undurchlässig für einen Teil der von außen auf das optoelektronische Bauteil einfallenden Strahlung ist, wobei dieser Teil im Wesentlichen einem Wellenlängenbereich des zweiten Wellenlängenspektrums entspricht. Der restliche Teil der einfallenden elektromagnetischen Strahlung, der durch die Filterschicht durchtreten kann, wird beispielsweise von der Filterschicht oder von der organischen Schichtenfolge beziehungsweise einer Elektrode in der organischen Schichtenfolge reflektiert und zurück durch die Filterschicht und/oder die Wellenlängenkonversionsschicht nach außen abgestrahlt.

Der Teil der elektromagnetischen Strahlung, für den die Filterschicht durchlässig ist, entspricht elektromagnetischer Strahlung mit einem Wellenlängenbereich des ersten Wellenlängenspektrums. Somit kommt es auch im ausgeschalteten Zustand zu einer Überlagerung von elektromagnetischer Strahlung mit einem Wellenlängenbereich des ersten Wellenlängenspektrums und einer elektromagnetischen Strahlung mit dem Wellenlängenbereich des zweiten Wellenlängenspektrums, so dass sich ein gewünschter, vorzugsweise nicht gelblicher Farbeindruck einstellt.

In verschiedenen Ausführungsformen der Erfindung ist die Filterschicht dazu eingerichtet, die elektromagnetische Strahlung mit dem dritten Wellenlängenspektrum in eine elektromagnetische Strahlung aus einem nicht sichtbaren Wellenlängenbereich zu konvertieren. Beispielsweise wird in der Filterschicht elektromagnetische Strahlung aus einem gelben Wellenlängenbereich in elektromagnetische Strahlung aus einem infraroten Wellenlängenbereich umgewandelt.

Die Filterschicht ist für elektromagnetische Strahlung mit dem ersten Wellenlängenspektrum transparent.

Anders ausgedrückt ist die Filterschicht dazu eingerichtet, elektromagnetische Strahlung mit dem dritten Wellenlängenspektrum in Wärme beziehungsweise Wärmestrahlung umzuwandeln, während elektromagnetische Strahlung mit dem ersten Wellenlängenspektrum die Filterschicht ungehindert passieren kann. Dies bedeutet insbesondere, dass die von der organischen Schichtenfolge im Betrieb abgestrahlte elektromagnetische Strahlung durch die Filterschicht im Wesentlichen unbeeinflusst bleibt.

Die Filterschicht ist also beispielsweise dazu eingerichtet, die elektromagnetische Strahlung mit dem dritten Wellenlängenspektrum zu absorbieren. Die Filterschicht kann hierfür in verschiedenen Ausführungsbeispielen einen molekularen Filter aufweisen. Die Filterschicht kann also in verschiedenen Ausführungsbeispielen auch als Absorptionsschicht für elektromagnetische Strahlung mit dem dritten Wellenlängenspektrum verstanden werden.

Insbesondere kann eine solche Ausführungsform vorteilhaft sein für Anwendungen, in denen lichtemittierende Bauteile mit organischen lichtemittierenden Dioden (OLEDs) verwendet werden, beispielsweise etwa als Blitzlicht bei Mobiltelefonanwendungen mit Kamera. Beispielsweise können solche lichtemittierenden Bauteile blaue OLEDs und einen Phosphorkonversionsstoff aufweisen. Dabei kann es sein, dass der Phosphorkonversionsstoff durch ein transparentes Cover oder eine Linse von außen sichtbar ist, wenn ein solches lichtemittierendes Bauteil nicht in Betrieb ist, was zu einem beispielsweise aus ästhetischen Gründen unerwünschten Farbeindruck führen kann. Ein solcher unerwünschter Farbeindruck lässt sich zwar durch Fresneloptiken oder Mikrolinsenarrays verringern, jedoch kann weiterhin ein störender Farbeindruck erhalten bleiben.

Alternativ oder zusätzlich kann das erste Spektrum beispielsweise auch einen grünen Wellenlängenbereich aufweisen und das zweite Spektrum einen roten Wellenlängenbereich, so dass das optoelektronische Bauteil ebenfalls im Betrieb einen weißen Leuchteindruck bei einem Betrachter ermöglichen kann. Insbesondere können das erste Spektrum, das zweite Spektrum, und der Teil der von außen auf das optoelektronische Bauteil einfallenden und reflektierten Strahlung, der nicht von der Filterschicht herausgefiltert wird, auch entsprechend einem anderen gewünschten Farbeindruck jeweils im Betrieb und im ausgeschalteten Zustand des optoelektronischen Bauteils gewählt werden.

Gemäß zumindest einer Ausführungsform weist die Wellenlängenkonversionsschicht zumindest einen der folgenden Farbstoffe auf: einen organischen Farbstoff, einen anorganischen Farbstoff, Perylen, Kumarin und/oder einen fluoreszierenden Farbstoff.

Weiterhin kann die organische Schichtenfolge insbesondere als organische Leuchtdiode (OLED) ausgeführt sein. Eine OLED kann dabei eine organische Schicht oder eine Schichtenfolge mit zumindest einer organischen Schicht aufweisen, mit einem aktiven Bereich, der im Betrieb elektromagnetische Strahlung aussenden kann. Weiterhin kann eine OLED eine erste Elektrode und eine zweite Elektrode aufweisen, wobei die organische Schicht oder die Schichtenfolge mit zumindest einer organischen Schicht mit dem aktiven Bereich zwischen der ersten und zweiten Elektrode angeordnet sein kann. Die erste und die zweite Elektrode können dabei geeignet sein, "Löcher" beziehungsweise Elektronen in den aktiven Bereich zu injizieren, die dort unter Emission von elektromagnetischer Strahlung rekombinieren können.

Weiterhin kann die erste Elektrode auf einem Substrat angeordnet sein. Über der ersten Elektrode kann die organische Schicht oder die Schichtenfolge mit einer oder mehreren funktionalen Schichten aus organischen Materialien aufgebracht sein. Die funktionalen Schichten, die den aktiven Bereich umfassen können, können dabei beispielsweise Elektronentransportschichten, elektrolumineszierende Schichten und/oder Lochtransportschichten aufweisen. Über den funktionalen Schichten beziehungsweise über der zumindest einen organischen Schicht kann die zweite Elektrode aufgebracht sein.

Beispielsweise kann das Substrat Glas, Quarz, Kunststofffolien, Metall, Metallfolien, Siliziumwafer oder ein beliebiges anderes geeignetes Substratmaterial umfassen. Beispielsweise kann das Substrat auch als Schichtenfolge oder Laminat mehrerer Schichten ausgeführt sein. Ist die Halbleiterschichtenfolge als so genannter "Bottom-Emitter" ausgeführt, das heißt, dass die im aktiven Bereich erzeugte elektromagnetische Strahlung durch das Substrat abgestrahlt werden kann, so kann das Substrat vorteilhafterweise eine Transparenz für zumindest einen Teil der elektromagnetischen Strahlung aufweisen. Die Wellenlängenkonversionsschicht und die Filterschicht können dabei auf einer der Halbleiterschichtenfolge abgewandten Seite des Substrats angeordnet sein.

Gemäß zumindest einer Ausführungsform weist mindestens eine der Elektroden ein transparentes leitendes Oxid, ein Metall oder ein leitendes organisches Material auf oder besteht aus einem solchen.

In der Bottom-Emitter-Konfiguration kann vorteilhafterweise die erste Elektrode transparent für zumindest einen Teil der elektromagnetischen Strahlung sein. Eine transparente erste Elektrode, die als Anode ausgeführt sein kann und somit als positive Ladungen oder "Löcher" injizierendes Material dienen kann, kann beispielsweise ein transparentes leitendes Oxid aufweisen oder aus einem transparenten leitenden Oxid bestehen. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO2 oder In2O3 gehören auch ternäre Metallsauerstoffverbindungen, wie beispielsweise Zn2SnO4, CdSnO3, ZnSnO3, MgIn2O4, GaInO3, Zn2In2O5 oder In4Sn3O12 oder Mischungen unterschiedlicher transparenter leitender Oxide zu der Gruppe der TCOs. Weiterhin müssen die TCOs nicht zwingend einer stöchiometrischen Zusammensetzung entsprechen und können auch p- oder n-dotiert sein. Alternativ oder zusätzlich kann die erste Elektrode auch ein Metall, beispielsweise Silber, aufweisen.

Die Halbleiterschichtenfolge mit zumindest einer organischen Schicht kann Polymere, Oligomere, Monomere, organische kleine Moleküle ("organic small molecules") oder andere organische nichtpolymere Verbindungen oder Kombinationen daraus aufweisen. Insbesondere kann es vorteilhaft sein, wenn eine funktionale Schicht der Schichtenfolge als Lochtransportschicht ausgeführt ist, um eine effektive Löcherinjektion in eine elektrolumineszierende Schicht oder einen elektrolumineszierenden Bereich zu ermöglichen. Solche Strukturen den aktiven Bereich oder die weiteren funktionalen Schichten und Bereiche betreffend sind dem Fachmann insbesondere hinsichtlich Materialien, Aufbau, Funktion und Struktur bekannt und werden daher an dieser Stelle nicht näher erläutert.

Die zweite Elektrode kann als Kathode ausgeführt sein und somit als Elektronen induzierendes Material dienen. Als Kathodenmaterial können sich unter anderem insbesondere Aluminium, Barium, Indium, Silber, Gold, Magnesium, Calcium oder Lithium sowie Verbindungen, Kombinationen und Legierungen davon als vorteilhaft erweisen. Zusätzlich oder alternativ kann die zweite Elektrode auch transparent ausgeführt sein. Das bedeutet insbesondere, dass die OLED auch als "Top-Emitter" ausgeführt sein kann, das heißt, dass die im aktiven Bereich erzeugte elektromagnetische Strahlung auf der dem Substrat abgewandten Seite der Halbleiterschichtenfolge abgestrahlt werden kann. Die Wellenlängenkonversionsschicht und die Filterschicht können dabei über der Halbleiterschichtenfolge und insbesondere über der zweiten Elektrode angeordnet sein.

Soll eine Elektrode, die die metallische Schicht aufweist oder aus einer solchen besteht, durchlässig für das von dem organischen Schichtstapel ausgesandte Licht ausgebildet sein, so kann es vorteilhaft sein, wenn die metallische Schicht hinreichend dünn ausgebildet ist. Bevorzugt liegt die Dicke einer solchen semitransparenten metallischen Schicht zwischen 1 nm und 100 nm, wobei die Grenzen eingeschlossen sind.

Weiterhin kann die erste Elektrode als Kathode und die zweite Elektrode als Anode ausgeführt sein, wobei die Halbleiterschichtenfolge dabei als Bottom- oder Top-Emitter ausgeführt sein kann. Auch kann die Halbleiterschichtenfolge gleichzeitig als Top-Emitter und als Bottom-Emitter ausgebildet sein.

Die Halbleiterschichtenfolge kann als aktiven Bereich beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Strukur) aufweisen. Die Halbleiterschichtenfolge kann neben dem aktiven Bereich weitere funktionelle Schichten und funktionelle Bereiche umfassen, etwa p- oder n-dotierte Ladungsträgertransportschichten, also Elektronen- oder Löchertransportschichten, p- oder n-dotierte Confinement- oder Cladding-Schichten, Pufferschichten und/oder Elektroden sowie Kombinationen daraus. Solche Strukturen den aktiven Bereich oder die weiteren funktionellen Schichten und Bereiche betreffend sind dem Fachmann insbesondere hinsichtlich Aufbau, Funktion und Struktur bekannt und werden von daher an dieser Stelle nicht näher erläutert.

Bei einer weiteren Ausführungsform weist die Wellenlängenkonversionsschicht zumindest einen Wellenlängenkonversionsstoff auf. Der Wellenlängenkonversionsstoff kann dabei beispielsweise Partikel aus der Gruppe der Cer-dotierten Granate aufweisen, dabei insbesondere Cer-dotiertes Yttriumaluminiumgranat (Y3Al5012:Ce, YAG:Ce), Cer-dotiertes Terbiumaluminiumgranat (TAG:Ce), Cer-dotiertes Terbium-Yttriumaluminiumgranat (TbYAG:Ce), Cer-dotiertes Gadolinium-Yttriumaluminiumgranant (GdYAG:Ce) und Cer-dotiertes Gadolinium-Terbium-Yttriumaluminiumgranat (GdTbYAG:Ce). Weitere mögliche Wellenlängenkonversionsstoffe können beispielsweise folgende sein:
- Granate der seltenen Erden und der Erdalkalimetalle, wie beispielsweise in der Druckschrift US 2004062699 A1 beschrieben, deren Offenbarungsgehalt diesbezüglich durch Rückbezug aufgenommen wird,
- Nitride, Sione und Sialone, wie beispielsweise in der Druckschrift DE 10147040 A1 beschrieben, deren Offenbarungsgehalt diesbezüglich durch Rückbezug aufgenommen wird,
- Orthosilikate, Sulfide, und Vanadate, wie beispielsweise in der Druckschrift WO 00/33390 A1 beschrieben, deren Offenbarungsgehalt diesbezüglich durch Rückbezug aufgenommen wird,
- Chlorosilikate, wie beispielsweise in der Druckschrift DE 10036940 A1 beschrieben, deren Offenbarungsgehalt diesbezüglich durch Rückbezug aufgenommen wird, und
- Aluminate, Oxide, Halophosphate, wie beispielsweise in der Druckschrift US 6,616,862 B2 beschrieben, deren Offenbarungsgehalt diesbezüglich durch Rückbezug aufgenommen wird.
Weiterhin kann die Wellenlängenkonversionsschicht auch geeignete Mischungen und Kombinationen der genannten Wellenlängenkonversionsstoffe umfassen.

Weiterhin kann die Wellenlängenkonversionsschicht ein transparentes Matrixmaterial umfassen, wobei der Wellenlängenkonversionsstoff in das Matrixmaterial eingebettet oder daran chemisch gebunden sein kann. Das transparente Matrixmaterial kann beispielsweise einen transparenten Kunststoff aufweisen, etwa Silikone, Epoxide, Acrylate, Imide, Carbonate, Olefine oder Derivate davon. Die Wellenlängenkonversionsschicht kann dabei als Folie ausgeführt sein. Darüber hinaus kann die Wellenlängenkonversionsschicht auch auf einem Substrat, das etwa Glas oder einen transparenten Kunststoff aufweist, aufgebracht sein.

Gemäß zumindest einer Ausführungsform des optoelektronischen Bauteils weist die Wellenlängenkonversionsschicht zumindest einen Wellenlängenkonversionsstoff aus der Gruppe der Granate auf.

Gemäß zumindest einer Ausführungsform des optoelektronischen Bauteils ist der Wellenlängenkonversionsstoff in ein Matrixmaterial eingebettet und das Matrixmaterial weist einen transparenten Kunststoff auf.

Gemäß zumindest einer Ausführungsform des optoelektronischen Bauteils ist die Wellenlängenkonversionsschicht als Folie ausgebildet.

Gemäß zumindest einer Ausführungsform des optoelektronischen Bauteils weisen die zweiten Bereiche jeweils eine Streuschicht auf.

Gemäß zumindest einer Ausführungsform des optoelektronischen Bauteils ist die Streuschicht der Filterschicht im Strahlengang der von der organischen Schichtenfolge abgestrahlten elektromagnetischen Strahlung nachgeordnet.

Gemäß zumindest einer Ausführungsform des optoelektronischen Bauteils ist die Filterschicht der Streuschicht im Strahlengang der von der organischen Schichtenfolge abgestrahlten elektromagnetischen Strahlung nachgeordnet.

Gemäß zumindest einer Ausführungsform des optoelektronischen Bauteils sind die Filterschicht und die Streuschicht in den zweiten Bereichen miteinander kombiniert.

Gemäß zumindest einer Ausführungsform des optoelektronischen Bauteils ist eine Streuschicht vorgesehen, die der strukturierten Schicht im Strahlengang der von der organischen Schichtenfolge abgestrahlten elektromagnetischen Strahlung nachgeordnet ist.

Gemäß zumindest einer Ausführungsform des optoelektronischen Bauteils weist die Streuschicht eine aufgeraute Oberfläche auf.

Gemäß zumindest einer Ausführungsform des optoelektronischen Bauteils umfasst die Streuschicht reflektierende Partikel.

Gemäß zumindest einer Ausführungsform des optoelektronischen Bauteils umfasst die Streuschicht zumindest eines der folgenden reflektierenden Partikel: Quarzglas, Titanoxid, Aluminiumoxid.

In einer weiteren Ausführungsform der Erfindung weisen die zweiten Bereiche jeweils eine Streuschicht auf, die dazu eingerichtet ist, elektromagnetische Strahlung, insbesondere Licht, welches gerichtet auf die Schicht trifft, ungerichtet, also mit verschiedenen Richtungen, weiterzuleiten beziehungsweise abzugeben.

Die organische Schichtenfolge strahlt üblicherweise elektromagnetische Strahlung in gerichteter Form ab, das heißt, die von der organischen Schichtenfolge abgegebene elektromagnetische Strahlung weist überwiegend eine einzelne Richtung auf, die im Wesentlichen senkrecht zur Schichtanordnung der organischen Schichtenfolge ist. Die von der Wellenlängenkonversionsschicht abgegebene elektromagnetische Strahlung kann in verschiedenen Ausführungsbeispielen ungerichtet oder isotrop erfolgen. Durch die Streuschicht wird auch die elektromagnetische Strahlung mit dem ersten Spektrum, die von der organischen Schichtenfolge abgegeben wird, ungerichtet abgestrahlt. Somit kommt es bei einer Überlagerung der isotrop abgestrahlten elektromagnetischen Strahlung mit dem zweiten Spektrum und der durch die Streuschicht gestreuten elektromagnetischen Strahlung mit dem ersten Spektrum zu einer Überlagerung jeweils ungerichteter elektromagnetischer Strahlung. Dies führt vorteilhafterweise zu einem gleichmäßigem Lichteindruck des optoelektronischen Bauteils.

Die Streuschicht kann der Filterschicht im Strahlengang der von der organischen Schichtenfolge abgestrahlten elektromagnetischen Strahlung nachgeordnet sein. Alternativ kann auch die Filterschicht der Streuschicht im Strahlengang der von der organischen Schichtenfolge abgestrahlten elektromagnetischen Strahlung nachgeordnet sein. Wiederum alternativ können die Filterschicht und die Streuschicht in den zweiten Bereichen miteinander kombiniert sein.

In einem weiteren Ausführungsbeispiel kann auch von der Wellenlängenkonversionsschicht eine gerichtete elektromagnetische Strahlung abgegeben werden. Insbesondere für diesen Fall kann es sinnvoll sein, eine Streuschicht vorzusehen, die der strukturierten Schicht, das heißt den ersten und den zweiten Bereichen, im Strahlengang der von der organischen Schichtenfolge abgestrahlten elektromagnetischen Strahlung nachgeordnet ist. Durch die Streuschicht wird wiederum gerichtetes Licht beziehungsweise gerichtete elektromagnetische Strahlung aus den ersten und zweiten Bereichen in ungerichtete Strahlung umgesetzt. Dies kann beispielsweise zu einem angenehmeren Farbeindruck bei einem Betrachter führen.

Die Streuung kann in verschiedenen Ausführungsbeispielen dadurch erreicht werden, dass die Streuschicht eine aufgeraute Oberfläche aufweist. In anderen Ausführungsbeispielen kann die Streuschicht zur Streuung reflektierende Partikel umfassen, welche einfallendes Licht beispielsweise unter jeweils verschiedenen Abstrahlwinkeln reflektieren. Die reflektierenden Partikel können dabei beispielsweise durch Quarzglas, durch Titandioxid, durch Aluminiumoxid oder ähnliche transparente Teilchen gebildet sein. Die Partikel weisen dabei vorzugsweise eine Partikelgröße im Bereich von etwa 100 nm bis wenige µm auf. Die Partikel sind dabei vorzugsweise in eine Matrix eingebettet, beispielsweise eine Folie oder eine Silikonmatrix. Alternativ können auch andere transparente Kunststoffe als Trägermaterial für die reflektierenden Partikel verwendet werden.

In einer weiteren Ausführungsform der Erfindung weist das optoelektronische Bauteil eine zweite Wellenlängenkonversionsschicht auf, die den ersten Bereichen und/oder den zweiten Bereichen im Strahlengang der von der organischen Schichtenfolge abgestrahlten elektromagnetischen Strahlung nachgeordnet ist. Die zweite Wellenlängenkonversionsschicht ist dabei eingerichtet, zumindest teilweise elektromagnetische Strahlung aus einem Wellenlängenbereich, der unterhalb eines Wellenlängenbereichs des ersten Spektrums liegt, in eine elektromagnetische Strahlung aus dem Wellenlängenbereich des ersten Spektrums umzuwandeln. Durch die Umwandlung der elektromagnetischen Strahlung aus dem Wellenbereich, der unterhalb des Wellenlängenbereichs des ersten Spektrums und damit üblicherweise in einem nicht sichtbaren Wellenlängenbereich liegt, in den Wellenlängenbereich des ersten Spektrums kann erreicht werden, dass bei einem Einfall von elektromagnetischer Strahlung von außen auf das optoelektronische Bauteil entsprechend die Intensität der elektromagnetischen Strahlung im Wellenlängenbereich des ersten Spektrums verstärkt wird. Das von der zweiten Wellenlängenkonversionsschicht konvertierte Licht kann dabei in Abhängigkeit der gewählten Ausführungsform durch den zweiten Bereich reflektiert und nach außen abgestrahlt werden und/oder in den ersten Bereichen mit der ersten Wellenlängenkonversionsschicht in elektromagnetische Strahlung mit einem dem zweiten Wellenlängenspektrum entsprechenden Wellenlängenbereich konvertiert werden. Vorzugsweise ist die zweite Wellenlängenkonversionsschicht dazu eingerichtet, elektromagnetische Strahlung aus einem ultravioletten (UV) Wellenlängenbereich in eine elektromagnetische Strahlung aus einem blauen Wellenlängenbereich umzuwandeln.

Somit kann bei einem optoelektronischen Bauteil gemäß einer der Ausführungsformen bei einer Bestrahlung mit Sonnenlicht ein UV-Anteil des Sonnenlichts zunächst in elektromagnetische Strahlung aus einem blauen Wellenlängenbereich umgewandelt werden, welche alleine oder gemeinsam mit einer nachfolgenden in einen gelben Wellenlängenbereich umgewandelten elektromagnetischen Strahlung eine Intensität des Leuchteindrucks des optoelektronischen Bauteils erhöht.

In einem weiteren Ausführungsbeispiel der Erfindung weisen die ersten Bereiche jeweils eine zweite Filterschicht auf, die der ersten Wellenlängenkonversionsschicht in den zweiten Bereichen im Strahlengang der von der organischen Schichtenfolge abgestrahlten elektromagnetischen Strahlung nachgeordnet ist. Die zweite Filterschicht ist dabei für eine elektromagnetische Strahlung mit einem vierten Wellenlängenspektrum, das zumindest einem Teil des ersten Wellenlängenspektrums entspricht, wenigstens teilweise undurchlässig. Durch die zweite Filterschicht kann vorteilhaft erreicht werden, dass weniger oder keine elektromagnetische Strahlung aus einem Wellenlängenbereich, der dem Absorptionsspektrum der ersten Wellenlängenkonversionsschicht entspricht, in dieser Wellenlängenkonversionsschicht in elektromagnetische Strahlung mit dem zweiten Wellenlängenspektrum umgewandelt wird. Somit kann die Intensität der elektromagnetischen Strahlung mit dem zweiten Wellenlängenspektrum, welche von der Wellenlängenkonversionsschicht abgegeben wird, reduziert werden. Dies kann zu einem weniger gelblichen Farbeindruck des optoelektronischen Bauteils führen.

In verschiedenen Ausführungsformen kann die zweite Filterschicht dazu eingerichtet sein, die elektromagnetische Strahlung mit dem vierten Spektrum zumindest teilweise zu absorbieren. Alternativ oder zusätzlich kann die zweite Filterschicht auch dazu eingerichtet sein, die elektromagnetische Strahlung mit dem vierten Spektrum zumindest teilweise zu reflektieren.

Für verschiedene Ausführungsbeispiele der Erfindung, bei denen die organische Schichtenfolge als Top-Emitter-Struktur ausgeführt ist, kann das optoelektronische Bauteil eine Verkapselung aufweisen, die der strukturierten Schicht im Strahlengang, der von der organischen Schichtenfolge abgestrahlten elektromagnetischen Strahlung vorgeordnet oder nachgeordnet ist. Anders ausgedrückt kann die strukturierte Schicht gemeinsam mit der organischen Schichtenfolge verkapselt werden oder alternativ außerhalb einer Verkapselung der organischen Schichtenfolge liegen. Die Verkapselung kann jeweils als Dünnschichtverkapselung ausgeführt sein.

Die zweite Wellenlängenkonversionsschicht kann einen ähnlichen Aufbau wie die erste Wellenlängenkonversionsschicht aufweisen. Insbesondere können in der zweiten Wellenlängenkonversionsschicht entsprechende Konversionsstoffe vorgesehen sein, die jedoch in ihrer Anordnung und/oder Zusammensetzung und/oder Konzentration an das in der zweiten Wellenlängenkonversionsschicht gewünschte Absorptionsspektrum und Emissionsspektrum angepasst sind.

Auch die Filterschichten können als entsprechende Konversionsschichten ausgeführt sein, wobei die jeweils herauszufilternden Anteile der elektromagnetischen Strahlung jeweils vorzugsweise in elektromagnetische Strahlung aus einem nicht sichtbaren Wellenlängenbereich, vorzugsweise einem infraroten Wellenlängenbereich umgewandelt werden. Alternativ können die Filterschichten auch als pigmentbasierte Filter realisiert sein, die für die Filterung entsprechende farbige Pigmente aufweisen.

Weitere Vorteile und vorteilhafte Ausführungsformen und Weiterbildungen der erfindungsgemäßen Gegenstände ergeben sich aus den im Folgenden in Verbindung mit den Figuren beschriebenen Ausführungsbeispielen.

Es zeigen:
- Figuren 1A und 1B: schematische Darstellungen eines optoelektronischen Bauteils gemäß einem Ausführungsbeispiel im Betrieb und im ausgeschaltetem Zustand,
- Figur 2: ein erstes beispielhaftes spektrales Diagramm,
- Figur 3: verschiedene Ausführungsformen einer strukturierten Schicht,
- Figuren 4A, 4B und 4C: schematische Darstellungen eines optoelektronischen Bauteils gemäß weiterer Ausführungsbeispiele,
- Figur 5: eine schematische Darstellung eines optoelektronischen Bauteils gemäß einem weiteren Ausführungsbeispiel,
- Figur 6: eine schematische Darstellung eines optoelektronischen Bauteils gemäß einem weiteren Ausführungsbeispiel,
- Figur 7: eine schematische Darstellung eines optoelektronischen Bauteils gemäß einem weiteren Ausführungsbeispiel, und
- Figur 8: ein zweites beispielhaftes spektrales Diagramm.

In den Ausführungsbeispielen und Figuren sind gleiche oder gleich wirkende Bestandteile jeweils mit den gleichen Bezugszeichen versehen. Die dargestellten Elemente und deren Größenverhältnisse untereinander sind grundsätzlich nicht als maßstabsgerecht anzusehen, vielmehr können einzelne Elemente, wie zum Beispiel Schichten, zur besseren Darstellbarkeit und/oder zum besseren Verständnis übertrieben dick dargestellt sein.

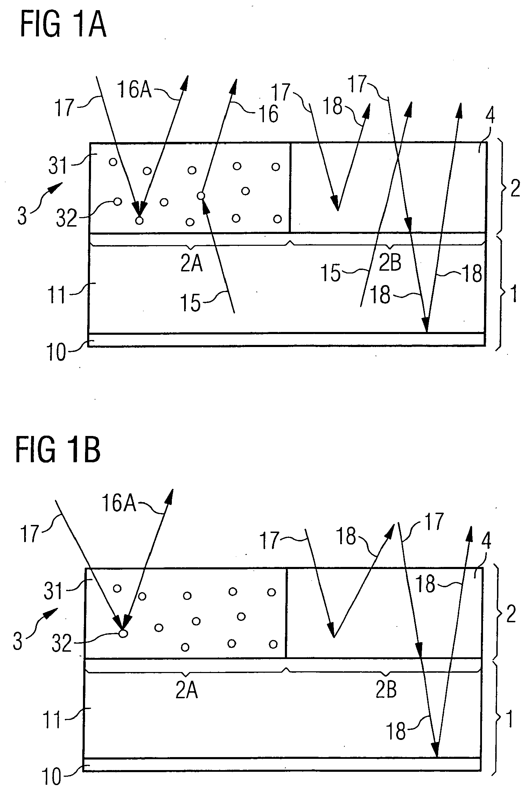

In den Figuren 1A und 1B ist ein Ausführungsbeispiel für ein optoelektronisches Bauteil gezeigt. Dabei wird in Verbindung mit der Figur 1A das optoelektronische Bauteil im Betrieb beschrieben, während die Figur 1B das optoelektronische Bauteil im ausgeschalteten Zustand zeigt. Die folgende Beschreibung kann sich gleichermaßen auf die Figuren 1A und 1B beziehen.

Das optoelektronische Bauteil weist eine organische Schichtenfolge 1 und eine Elektrode 10 und einen aktiven Bereich 11 auf. Die organische Schichtenfolge 1 kann dabei, wie im allgemeinen Teil der Beschreibung ausgeführt, funktionelle Schichten oder Schichtenfolgen aufweisen und ist beispielsweise als OLED ausgeführt. Insbesondere ist der aktive Bereich 11 der organischen Schichtenfolge 1 geeignet, elektromagnetische Strahlung 15 mit einem ersten Wellenlängenspektrum zu emittieren.

Im Strahlengang der elektromagnetischen Strahlung 15 mit dem ersten Wellenlängenspektrum ist eine strukturierte Schicht angeordnet, welche einen ersten Bereich 2A und einen zweiten Bereich 2B umfasst. Der erste Bereich 2A weist eine Wellenlängenkonversionsschicht 3 auf, die einen Wellenlängenkonversionsstoff 32 umfasst. Wie in dem Ausführungsbeispiel gezeigt, kann der Wellenlängenkonversionsstoff 32 beispielsweise in ein Matrixmaterial 31 eingebettet sein. Der zweite Bereich 2B weist eine vierte Schicht 4 auf.

Der Wellenlängenlängenkonversionsstoff 32 ist dabei geeignet, zumindest teilweise ein Teilspektrum der elektromagnetischen Strahlung 15 mit dem ersten Wellenlängenspektrum in elektromagnetische Strahlung 16 mit einem zweiten Wellenlängenspektrum umzuwandeln. Geeignet für den Wellenlängenkonversionsstoff 32 können hierbei insbesondere Materialien sein, die ein Absorptionsspektrum aufweisen, das zumindest eine spektrale Komponente, insbesondere einen Wellenlängenbereich enthält, der auch in dem ersten Wellenlängenspektrum enthalten ist. Die absorbierte elektromagnetische Strahlung kann dann vorzugsweise mit einer anderen Wellenlänge als die elektromagnetische Strahlung 15 mit dem ersten Wellenlängenspektrum re-emittiert werden.

Die Filterschicht 4 ist für eine elektromagnetische Strahlung mit einem dritten Wellenlängenspektrum, das zumindest einem Teil des zweiten Wellenlängenspektrums entspricht, undurchlässig. Die elektromagnetische Strahlung 15 mit dem ersten Wellenlängenspektrum kann in diesem Ausführungsbeispiel ungehindert und im Wesentlichen ohne Veränderung seiner spektralen Komponenten durch die Filterschicht 4 hindurch treten. Anders ausgedrückt ist die Filterschicht 4 für elektromagnetische Strahlung 15 mit dem ersten Wellenlängenspektrum transparent.

Beispielsweise werden spektrale Komponenten einer von außen auf das optoelektronische Bauteil einfallenden elektromagnetischen Strahlung 17, die dem dritten Wellenlängenspektrum entspricht, in eine elektromagnetische Strahlung aus einem nicht sichtbaren Wellenlängenbereich umgewandelt, welcher aus Übersichtsgründen in der vorliegenden Darstellung nicht gezeigt ist. Ein verbleibender Anteil von spektralen Komponenten der elektromagnetischen Strahlung 17 wird als elektromagnetische Strahlung 18 alternativ reflektiert oder durch die Filterschicht 4 in die organische Schichtenfolge 1 transmittiert, wobei in diesem Fall eine Reflexion dieser elektromagnetischen Strahlung 18 an der Elektrode 10 zurück durch die Filterschicht 4 erfolgt. Beispielsweise entspricht die elektromagnetische Strahlung 18 in ihrem Wellenlängenbereich dem Wellenlängenbereich des ersten Wellenlängenspektrums der von der organischen Schichtenfolge abgestrahlten elektromagnetischen Strahlung 15. Dabei kann die elektromagnetische Strahlung 15 beziehungsweise die elektromagnetische Strahlung 18 einen blauen Wellenlängebereich umfassen.

Im ersten Bereich 2A beziehungsweise in der Konversionsschicht 3 werden spektrale Komponenten der elektromagnetischen Strahlung 17, die dem Wellenlängenbereich des ersten Wellenlängenspektrums beziehungsweise dem Absorptionsspektrum der Wellenlängenkonversionsschicht 3 entsprechen, durch den Wellenlängenkonversionsstoff 32 in elektromagnetische Strahlung 16 mit dem zweiten Wellenlängenspektrum umgewandelt.

Die von dem optoelektronischen Bauteil abgestrahlte elektromagnetische Strahlung umfasst somit gemäß dem in Figur 1A dargestellten Ausführungsbeispiel im Betrieb des Bauteils Anteile der elektromagnetischen Strahlung 15 mit dem ersten Wellenlängenspektrum, Anteile der elektromagnetischen Strahlung 16 mit dem zweiten Wellenlängenspektrum, die aus der Umwandlung der elektromagnetischen Strahlung 15 resultiert, Anteile der durch die Filterschicht 4 gefilterten elektromagnetischen Strahlung 18 und Anteile der elektromagnetischen Strahlung 16a, die aus der Umwandlung der einfallenden elektromagnetischen Strahlung 17 resultiert. Vorteilhafterweise ergibt sich somit eine elektromagnetische Strahlung aus einem gelben Wellenlängenbereich kombiniert mit einer elektromagnetischen Strahlung aus einem blauen Wellenlängenbereich, welche eine gewünschte, beispielsweise weißliche Abstrahlcharakteristik ergibt.

Im ausgeschalteten Zustand des optoelektronischen Bauteils, wie im Ausführungsbeispiel in Figur 1B dargestellt, fällt wiederum elektromagnetische Strahlung 17 von außen auf das Bauteil ein. Wie zuvor beschrieben, erfolgt in der Wellenlängenkonversionsschicht 3 eine Konvertierung der elektromagnetischen Strahlung 17 in elektromagnetische Strahlung 16A und in der Filterschicht 4 eine Filterung der einfallenden elektromagnetischen Strahlung 17, welche in der gefilterten elektromagnetischen Strahlung 18 resultiert. Somit ergibt sich wiederum durch Kombination eines gelblichen Anteils der elektromagnetischen Strahlung 16A und eines bläulichen Anteils der elektromagnetischen Strahlung 18 ein nicht gelblicher, vorzugsweise weißlicher Farbeindruck bei einem Betrachter des optoelektronischen Bauteils in dessen ausgeschaltetem Zustand.

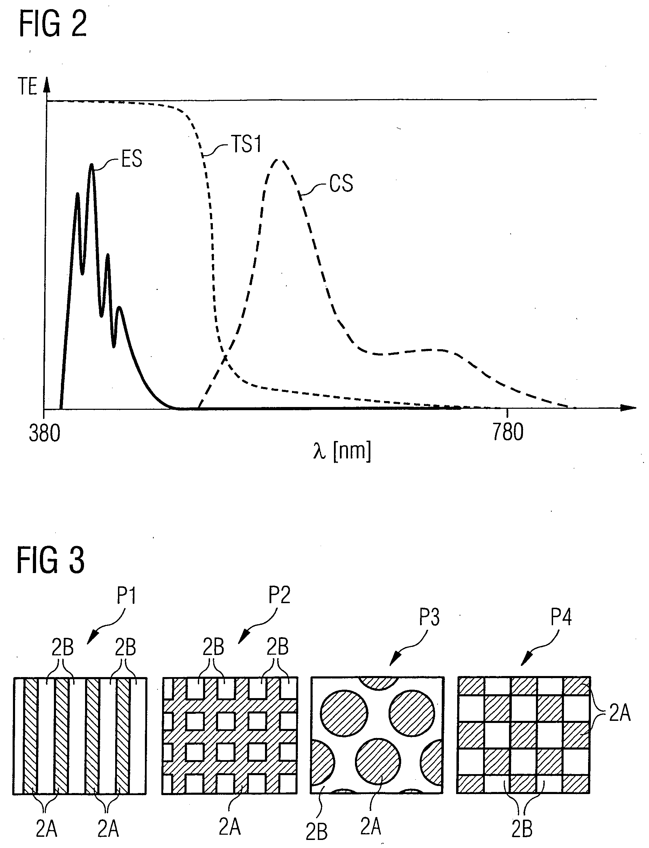

Figur 2 zeigt ein beispielhaftes spektrales Diagramm mit verschiedenen Transmissionscharakteristiken beziehungsweise Emissionscharakteristiken in Abhängigkeit einer Wellenlänge λ. Eine Emissionscharakteristik beziehungsweise ein Emissionsspektrum ES stellt beispielsweise einen spektralen Verlauf der elektromagnetischen Strahlung 15, die von der organischen Schichtenfolge 1 abgestrahlt wird, dar. Das Emissionsspektrum ES umfasst dabei einen blauen Wellenlängenbereich. Ein Konversionsspektrum CS stellt das von der Wellenlängenkonversionsschicht 3 emittierte Wellenlängenspektrum dar, das beispielsweise der elektromagnetischen Strahlung 16, 16A zugrunde liegt. Das Konversionsspektrum CS umfasst demnach einen gelben Wellenlängenbereich beziehungsweise einen rot-grünen Wellenlängenbereich. Die mit TS1 bezeichnete Kurve gibt ein Transmissionsspektrum der Filterschicht 4 an. Dementsprechend ist die Filterschicht 4 für blaues Licht und damit für die von der organischen Schichtenfolge 1 abgestrahlte elektromagnetische Strahlung 15 durchlässig, während elektromagnetische Strahlung mit einem gelben Wellenlängenbereich beziehungsweise einem roten und grünen Wellenlängenbereich undurchlässig ist. Bei einer Bestrahlung der Filterschicht 4 beispielsweise mit Sonnenlicht, welches näherungsweise spektrale Komponenten in allen sichtbaren Wellenlängenbereichen aufweist, wird somit ein gelblicher Anteil beziehungsweise rötlicher und grünlicher Anteil herausgefiltert. Ein gelblicher Farbeindruck des optoelektronische Bauteils kann somit reduziert oder vermieden werden.

Figur 3 zeigt verschiedene Ausführungsbeispiele von Anordnungen erster und zweiter Bereiche 2A, 2B. In einem ersten Muster P1 sind die ersten und zweiten Bereiche 2A, 2B streifenförmig angeordnet, wobei eine Breite der jeweiligen Streifen einen Farbeindruck des optoelektronischen Bauteils beeinflussen kann. In einem zweiten Muster P2 sind die ersten und zweiten Bereiche 2A, 2B gekreuzt gestreift beziehungsweise gitterförmig angeordnet. In einem dritten Muster P3 sind die ersten Bereiche kreisförmig innerhalb der zweiten Bereiche 2B angeordnet. In einem weiteren beispielhaften Muster P4 weisen die ersten und zweiten Bereiche 2A, 2B quadratische Form auf, so dass sich beispielsweise ein schachbrettartiges Muster ergibt. Neben den hier dargestellten beispielhaften Mustern können die ersten und zweiten Bereiche 2A, 2B auch in anderen Formen oder in einer Kombination dieser und anderer Formen vorgesehen werden.

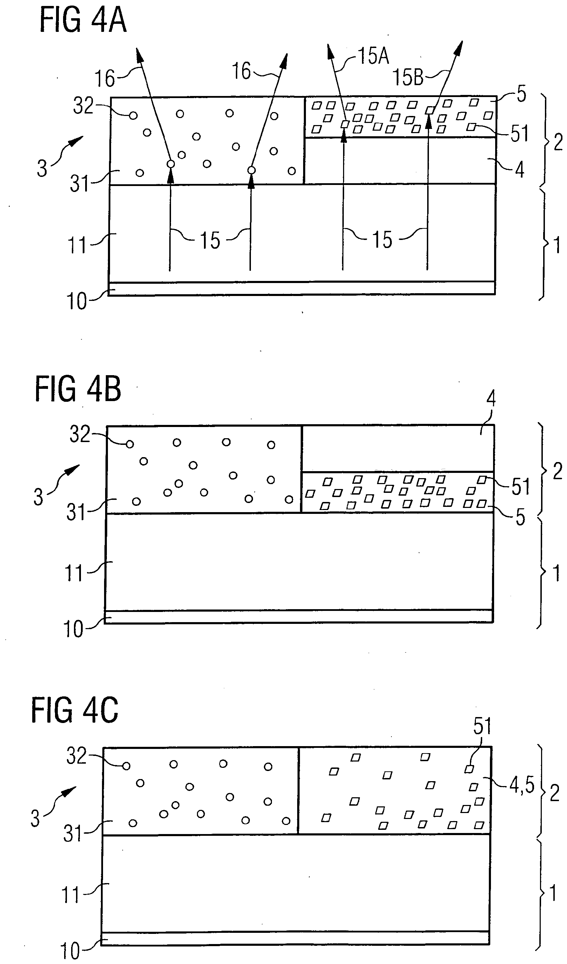

In den Figuren 4A, 4B und 4C sind weitere Ausführungsbeispiele eines optoelektronischen Bauteils dargestellt, deren prinzipielle Funktionsweise der des Ausführungsbeispiels gemäß der Figuren 1A und 1B entspricht. Dabei weisen die zweiten Bereiche jeweils eine Streuschicht 5 auf, die der Filterschicht 4 im Strahlengang der elektromagnetischen Strahlung 15 in Figur 4A nachgeordnet, in Figur 4B vorgeordnet und in Figur 4C mit der Filterschicht 4 kombiniert ist. Die folgende Beschreibung kann sich gleichermaßen auf die Figuren 4A, 4B und 4C beziehen.

Elektromagnetische Strahlung 15, die von der organischen Schichtenfolge 1 abgestrahlt wird, wird üblicherweise als gerichtete Strahlung abgegeben. Wenn die elektromagnetische Strahlung 15 in der Wellenlängenkonversionsschicht 3 auf den Wellenlängenkonversionsstoff 32 trifft, wird die Strahlung absorbiert und als elektromagnetische Strahlung 16 mit dem zweiten Spektrum re-emittiert. Die Re-Emission erfolgt dabei ungerichtet, das heißt die Abstrahlrichtung der emittierten Strahlung 16 erfolgt beispielsweise isotrop. Die elektromagnetische Strahlung 15 tritt jedoch durch die Filterschicht 4 ohne Richtungsänderung hindurch. Um eine Kombination gerichteter und ungerichteter elektromagnetischer Strahlung zu vermeiden, weist die Streuschicht 5 beispielsweise Streupartikel 51 auf, welche eine Richtungsänderung der elektromagnetischen Strahlung 15 bewirken, so dass diese als ungerichtete elektromagnetische Strahlung 15a, 15b ausgestrahlt wird. Somit lässt sich bei dem optoelektronischen Bauteil ein homogenerer, gleichmäßigerer Farbeindruck realisieren. Die Streuschicht 5 weist beispielsweise ein Matrixmaterial auf, in das die reflektierenden Partikel 51 eingebettet sind. Die Partikel können aus beliebigem transparentem Streumaterial wie zum Beispiel Aluminiumoxid, Titandioxid oder Quarzglas gebildet sein.

Die Streuwirkung der Streuschicht 5 gilt auch für eine hier nicht dargestellte einfallende elektromagnetische Strahlung 17 beziehungsweise eine reflektierte, gefilterte elektromagnetische Strahlung 18. Vorzugsweise weist die Streuschicht eine gleiche Abstrahlcharakteristik wie die Wellenlängenkonversionsschicht 3 auf.

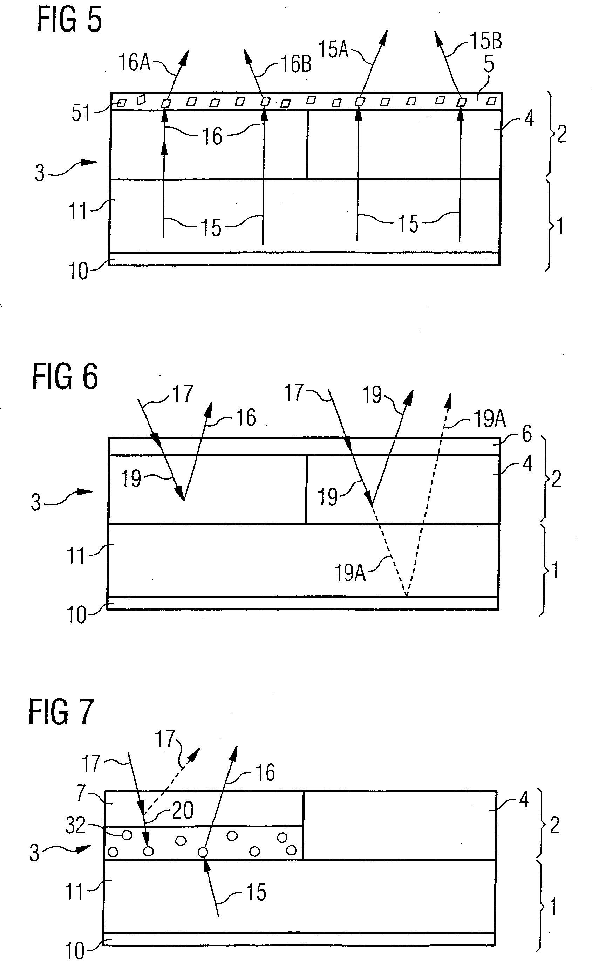

Figur 5 zeigt ein weiteres Ausführungsbeispiel eines optoelektronischen Bauteils, bei dem eine Streuschicht 5 sowohl über der Wellenlängenkonversionsschicht 3 als auch über der Filterschicht 4 vorgesehen ist. Beispielsweise ist in diesem Ausführungsbeispiel die Wellenlängenkonversionsschicht 3 dazu ausgebildet, die elektromagnetische Strahlung 16 mit dem zweiten Spektrum in gerichteter Form abzugeben. In diesem Fall tritt sowohl aus der Wellenlängenkonversionsschicht 3 als auch aus der Filterschicht 4 elektromagnetische Strahlung in gerichteter Form aus. Durch die Streuschicht 5 im Strahlengang dieser elektromagnetischen Strahlung erfolgt eine Streuung der Strahlung 15, 16 in ungerichtete Strahlung 15A, 15B, 16A, 16B. Dies führt wiederum zu einem homogenen Farbeindruck des optoelektronischen Bauteils.

Die Streuschicht weist auch in diesem Ausführungsbeispiel reflektierende Partikel 51 auf, welche in Aufbau und Funktion den Partikeln 51 der in den Figuren 4A, 4B und 4C gezeigten Ausführungsbeispiele entsprechen.

In weiteren Ausführungsbeispielen kann die Streuschicht 5 auch als Schicht mit einer aufgerauten Oberfläche realisiert werden, wobei die Streuung der elektromagnetischen Strahlung 15, 16 hierbei durch die aufgeraute Oberfläche der Streuschicht 5 erfolgt. In diesem Fall ist das Vorsehen von Partikeln 51 nicht zwingend erforderlich.

Figur 6 zeigt ein weiteres Ausführungsbeispiel eines optoelektronischen Bauteils, bei der der organischen Schichtenfolge 1 und der strukturierten Schicht 2 eine zweite Wellenlängenkonversionsschicht 6 nachgeordnet ist. Die zweite Wellenlängenkonversionsschicht 6 ist dabei dazu eingerichtet, zumindest teilweise elektromagnetische Strahlung aus einem Wellenlängenbereich, der unterhalb eines Wellenlängenbereichs des ersten Spektrums liegt, in eine elektromagnetische Strahlung aus dem Wellenlängenbereich des ersten Spektrums umzuwandeln. Beispielsweise kann durch die zweite Wellenlängekonversionsschicht 6 elektromagnetische Strahlung aus einem ultravioletten Wellenlängenbereich in einen blauen Wellenlängenbereich des ersten Spektrums umgewandelt werden.

Die zweite Konversionsschicht 6 weist dabei prinzipiell einen ähnlichen Aufbau beziehungsweise eine ähnliche Zusammensetzung wie die erste Wellenlängenkonversionsschicht 3 auf, wobei sich die Absorptionsspektren und Emissionsspektren der ersten und zweiten Wellenlängenkonversionsschicht 3, 6 jeweils voneinander unterscheiden. Die zweite Wellenlängenkonversionsschicht 6 weist demnach beispielsweise ein Absorptionsspektrum aus dem ultravioletten Wellenlängenbereich sowie ein Emissionsspektrum aus dem blauen Wellenlängenbereich auf.

Beispielsweise fällt im Betrieb oder im ausgeschalteten Zustand des optoelektronischen Bauteils elektromagnetische Strahlung 17, beispielsweise Sonnenlicht, auf die zweite Wellenlängenkonversionsschicht 6 des Bauteils. Die spektralen Anteile aus dem ultravioletten Wellenlängenbereich der elektromagnetischen Strahlung 17, welche dem Absorptionsspektrum der zweiten Wellenlängenkonversionsschicht 6 entsprechen, werden somit in eine elektromagnetische Strahlung 19 gemäß dem Emissionsspektrum der zweiten Wellenlängenkonversionsschicht 6 umgewandelt. Übrige spektrale Anteile der elektromagnetischen Strahlung 17, die nicht dem Absorptionsspektrum der zweiten Wellenlängenkonversionsschicht 6 entsprechen, können beispielsweise im Wesentlichen unverändert durch die Schicht 6 hindurch treten, wobei dies aus Übersichtsgründen in Figur 6 nicht dargestellt ist.

Da das Emissionsspektrum der Wellenlängenkonversionsschicht 6 im Wesentlichen dem Absorptionsspektrum der ersten Wellenlängenkonversionsschicht 3 entspricht, wird die elektromagnetische Strahlung 19 in der ersten Wellenlängenkonversionsschicht 3 in elektromagnetische Strahlung 16 mit dem zweiten Spektrum umgewandelt und abgestrahlt. Die elektromagnetische Strahlung 19 kann in der Filterschicht 4 reflektiert werden. Alternativ oder zusätzlich kann die elektromagnetische Strahlung 19 auch als elektromagnetische Strahlung 19A mit gleichem oder verändertem Wellenlängenspektrum in die organische Schichtenfolge 1 durchgelassen werden, wo sie beispielsweise an der Elektrode 10 nach außen reflektiert wird. Da die konvertierte elektromagnetische Strahlung 16 aus einem gelben Wellenlängenbereich und die konvertierte elektromagnetische Strahlung 19 beziehungsweise 19A aus einem blauen Wellenlängenbereich gemeinsam abgestrahlt werden, ergibt sich durch diese Strahlungsanteile wiederum ein weißlicher Farbeindruck des optoelektronischen Bauteils, sowohl im ausgeschaltetem als auch im eingeschaltetem Zustand.

In weiteren Ausführungsbeispielen kann die zweite Wellenlängenkonversionsschicht 6 auch nur über den ersten Bereichen 2A oder nur über den zweiten Bereichen 2B angeordnet sein.

In einem weiteren Ausführungsbeispiel in Figur 7 ist im Strahlengang der von der organischen Schichtenfolge abgestrahlten elektromagnetischen Strahlung 15 eine zweite Filterschicht der ersten Wellenlängenkonversionsschicht 3 nachgeordnet. Die zweite Filterschicht 7 ist dabei für eine elektromagnetische Strahlung mit einem vierten Wellenlängenspektrum, das zumindest einem Teil des ersten Wellenlängenspektrums entspricht, undurchlässig. Dadurch kann vorteilhafterweise verhindert werden, dass elektromagnetische Strahlung mit spektralen Anteilen aus dem Absorptionsspektrum der ersten Wellenlängenkonversionsschicht 3 von außerhalb des optoelektronischen Bauteils in die Wellenlängenkonversionsschicht 3 eindringen. Demzufolge können diese spektralen Anteile auch nicht in elektromagnetische Strahlung mit dem zweiten Wellenlängenspektrum umgesetzt werden. Dies führt zu einer Verringerung der Emission von elektromagnetischer Strahlung aus einem gelblichen Wellenlängenbereich.

Die zweite Filterschicht 7 kann beispielsweise die elektromagnetische Strahlung mit dem vierten Spektrum reflektieren. Alternativ oder zusätzlich kann die zweite Filterschicht 7 die elektromagnetische Strahlung mit dem vierten Spektrum auch absorbieren. Beispielsweise weist die zweite Filterschicht 7 eine komplementäre spektrale Charakteristik zu der ersten Filterschicht 4 auf.

In dem Ausführungsbeispiel in Figur 7 wird die elektromagnetische Strahlung 15, welche von der organischen Schichtenfolge emittiert wird, in der Wellenlängenkonversionsschicht 3 in elektromagnetische Strahlung 16 mit dem zweiten Spektrum konvertiert. Einfallende elektromagnetische Strahlung 17 wird an der zweiten Filterschicht 7 beispielsweise unverändert reflektiert oder derart transmittiert, dass eine elektromagnetische Strahlung 20 mit einem verbleibendem Spektrum auf die erste Wellenlängenkonversionsschicht 3 trifft. Da jedoch die elektromagnetische Strahlung 20 im Wesentlichen keine spektralen Anteile aus dem Absorptionsspektrum der Wellenlängenkonversionsschicht 3 aufweist, kann es zu keiner Re-Emission von umgewandelter elektromagnetischer Strahlung kommen.

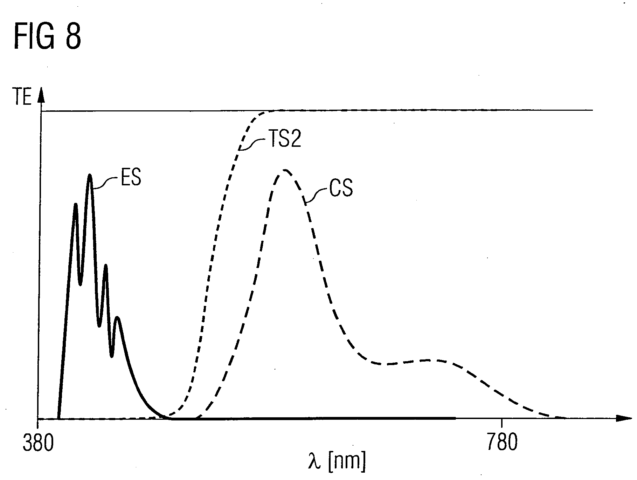

Figur 8 zeigt ein weiteres beispielhaftes spektrales Diagramm mit Transmissions- beziehungsweise Emissionsspektren. Das Emissionsspektrum ES der organischen Schichtenfolge 1 und das Konversionsspektrum CS der ersten Wellenlängenkonversionsschicht 3 entsprechen dabei beispielsweise den in Figur 2 gezeigten spektralen Verläufen. Ein Transmissionsspektrum TS2 stellt den beispielhaften spektralen Verlauf der zweiten Filterschicht 7 dar. Die zweite Filterschicht ist demnach undurchlässig für elektromagnetische Strahlung mit dem Emissionsspektrum der organischen Schichtenfolge, welche im Wesentlichen dem Absorptionsspektrum der Wellenlängenkonversionsschicht 3 entspricht.

Ein optoelektronisches Bauteil gemäß einem der dargestellten Ausführungsbeispiele kann beispielsweise als Komponente für ein Blitzlicht, für eine Mobiltelefonanwendung mit Kamera geeignet sein. Weiterhin kann ein solches optoelektronisches Bauteil auch für Beleuchtungseinrichtungen geeignet sein.

Die Erfindung ist nicht durch die Beschreibungen anhand der Ausführungsbeispiele auf diese beschränkt.

Insbesondere lassen sich bei dem optoelektronischen Bauteil die verschiedenen Ausführungsformen der Streuschichten, der zweiten Wellenlängenkonversionsschicht und der zweiten Filterschicht beliebig miteinander kombinieren.

Diese Patentanmeldung beansprucht die Priorität der deutschen Patentanmeldung 102007044597.2.

## Patentansprüche

1. Optoelektronisches Bauteil, umfassend
- eine organische Schichtenfolge (1), die im Betrieb eine elektromagnetische Strahlung (15) mit einem ersten Wellenlängenspektrum abstrahlt;
- eine strukturierte Schicht (2), die der organischen Schichtenfolge (1) im Strahlengang der von der organischen Schichtenfolge (1) abgestrahlten elektromagnetischen Strahlung (15) nachgeordnet ist und erste und zweite Bereiche (2A, 2B) aufweist; wobei
- die ersten Bereiche (2A) jeweils eine Wellenlängenkonversionsschicht (3) aufweisen, die eingerichtet ist, zumindest teilweise elektromagnetische Strahlung mit dem ersten Wellenlängenspektrum in eine elektromagnetische Strahlung (16) mit einem zweiten Wellenlängenspektrum umzuwandeln; und
- die zweiten Bereiche (2B) jeweils eine Filterschicht (4) aufweisen, die für eine elektromagnetische Strahlung mit einem dritten Wellenlängenspektrum, das zumindest einem Teil des zweiten Wellenlängenspektrums entspricht, wenigstens teilweise undurchlässig ist, wobei die ersten und zweiten Bereiche (2A, 2B) der strukturierten Schicht (2) lateral im Strahlengang des optoelektronischen Bauteils angeordnet sind; **dadurch gekennzeichnet, dass** die Filterschicht (4) für die elektromagnetische Strahlung (15) über den gesamten Wellenlängenspektrumsbereich, über dem die organische Schichtenfolge (1) abstrahlt transparent ist.

2. Optoelektronisches Bauteil nach dem vorherigen Anspruch, bei dem das erste Wellenlängenspektrum einen blauen Wellenlängenbereich umfasst und das zweite Wellenlängenspektrum einen gelben Wellenlängenbereich umfasst, wobei das optoelektronische Bauteil in einem ausgeschalteten Zustand bei einem Betrachter einen nichtgelblichen Farbeindruck erweckt.

3. Optoelektronisches Bauteil nach einem der vorherigen Ansprüche,
wobei die Filterschicht (4) eingerichtet ist, die elektromagnetische Strahlung mit dem dritten Wellenlängenspektrum in eine elektromagnetische Strahlung aus einem nicht sichtbaren Wellenlängenbereich umzuwandeln.

4. Optoelektronisches Bauteil nach dem vorherigen Anspruch, bei dem die Filterschicht (4) eingerichtet ist, die elektromagnetische Strahlung mit dem dritten Wellenlängenspektrum zu absorbieren.

5. Optoelektronisches Bauteil nach einem der vorherigen Ansprüche,
aufweisend eine zweite Wellenlängenkonversionsschicht (6), die den ersten Bereichen (2A) und/oder den zweiten Bereichen (2B) im Strahlengang der von der organischen Schichtenfolge (1) abgestrahlten elektromagnetischen Strahlung (15) nachgeordnet ist und eingerichtet ist, zumindest teilweise elektromagnetische Strahlung aus einem Wellenlängenbereich, der unterhalb eines Wellenlängenbereichs (15) des ersten Wellenlängenspektrums liegt, in eine elektromagnetische Strahlung aus dem Wellenlängenbereich des ersten Wellenlängenspektrums umzuwandeln.

6. Optoelektronisches Bauteil nach dem vorherigen Anspruch, bei dem die zweite Wellenlängenkonversionsschicht (6) dazu eingerichtet ist, elektromagnetische Strahlung aus einem ultravioletten Wellenlängenbereich in eine elektromagnetische Strahlung aus einem blauen Wellenlängenbereich umzuwandeln.

7. Optoelektronisches Bauteil nach einem der vorherigen Ansprüche,
bei dem die ersten Bereiche (2A) jeweils eine zweite Filterschicht (7) aufweisen, die der Wellenlängenkonversionsschicht (3) im Strahlengang der von der organischen Schichtenfolge (1) abgestrahlten elektromagnetischen Strahlung (15) nachgeordnet ist und die für eine elektromagnetische Strahlung mit einem vierten Wellenlängenspektrum, das zumindest einem Teil des ersten Wellenlängenspektrums entspricht, wenigstens teilweise undurchlässig ist.

8. Optoelektronisches Bauteil nach dem vorherigen Anspruch, bei dem die zweite Filterschicht (7) eingerichtet ist, die elektromagnetische Strahlung mit dem vierten Wellenlängenspektrum zumindest teilweise zu absorbieren.

9. Optoelektronisches Bauteil nach einem der Ansprüche 7 oder 8,
bei dem die zweite Filterschicht (7) eingerichtet ist, die elektromagnetische Strahlung mit dem vierten Wellenlängenspektrum zumindest teilweise zu reflektieren.

10. Optoelektronisches Bauteil nach dem vorherigen Anspruch, aufweisend eine Verkapselung, die der strukturierten Schicht (2) im Strahlengang der von der organischen Schichtenfolge (1) abgestrahlten elektromagnetischen Strahlung (15) vorgeordnet oder nachgeordnet ist.

11. Optoelektronisches Bauteil nach dem vorherigen Anspruch, bei dem die Verkapselung als Dünnschichtverkapselung ausgeführt ist.

12. Optoelektronisches Bauteil nach einem der vorherigen Ansprüche,
wobei die von einem Betrachter wahrgenommene vom optoelektronischen Bauteil emittierte elektromagnetische Strahlung einer Überlagerung der elektromagnetischen Strahlung (15) mit dem ersten Wellenlängenspektrum und der elektromagnetischen Strahlung (16) mit dem zweiten Wellenlängenspektrum entspricht.

13. Optoelektronisches Bauteil nach einem der vorherigen Ansprüche,
bei dem die strukturierte Schicht (2) gestreifte oder gekreuzt gestreifte oder kreisförmige oder dreiecksförmige oder rechteckige Bereiche oder eine Kombination der genannten Bereiche aufweist.

## Claims

1. Optoelectronic device, comprising
- an organic layer sequence (1), which emits an electromagnetic radiation (15) having a first wavelength spectrum during operation;
- a structured layer (2), which is disposed downstream of the organic layer sequence (1) in the beam path of the electromagnetic radiation (15) emitted by the organic layer sequence (1) and has first and second regions (2A, 2B);
wherein
- the first regions (2A) each have a wavelength conversion layer (3) formed to convert at least partially electromagnetic radiation having the first wavelength spectrum into an electromagnetic radiation (16) having a second wavelength spectrum; and
- the second regions (2B) each have a filter layer (4), which is at least partially opaque to an electromagnetic radiation having a third wavelength spectrum, which corresponds to at least one part of the second wavelength spectrum, wherein the first and second regions (2A, 2B) of the structured layer (2) are arranged laterally in the beam path of the optoelectronic device;
**characterized in that** the filter layer (4) is transparent to the electromagnetic radiation (15) over the entire wavelength range of the spectrum over which the organic layer sequence (1) emits.

2. Optoelectronic device according to the preceding claim,
in which the first wavelength spectrum comprises a blue wavelength range and the second wavelength spectrum comprises a yellow wavelength range, wherein the optoelectronic device gives an observer a non-yellowish color impression, in a switched-off state.

3. Optoelectronic device according to one of the preceding claims,
wherein the filter layer (4) is formed to convert the electromagnetic radiation having the third wavelength spectrum into an electromagnetic radiation from a non-visible wavelength range.

4. Optoelectronic device according to the preceding claim,
in which the filter layer (4) is formed to absorb the electromagnetic radiation having the third wavelength spectrum.

5. Optoelectronic device according to one of the preceding claims,
having a second wavelength conversion layer (6), which is disposed downstream of the first regions (2A) and/or the second regions (2B) in the beam path of the electromagnetic radiation (15) emitted by the organic layer sequence (1) and is formed to convert at least partially electromagnetic radiation from a wavelength range lying below a wavelength range (15) of the first wavelength spectrum into an electromagnetic radiation from the wavelength range of the first wavelength spectrum.

6. The optoelectronic device according to the preceding claim,
in which the second wavelength conversion layer (6) is formed to convert electromagnetic radiation from an ultraviolet wavelength range into an electromagnetic radiation from a blue wavelength range.

7. Optoelectronic device according to one of the preceding claims,
in which the first regions (2A) each have a second filter layer (7), which is disposed downstream of the wavelength conversion layer (3) in the beam path of the electromagnetic radiation (15) emitted by the organic layer sequence (1) and which is at least partially opaque to an electromagnetic radiation having a fourth wavelength spectrum, which corresponds to at least one part of the first wavelength spectrum.

8. Optoelectronic device according to the preceding claim,
in which the second filter layer (7) is formed at least partially to absorb the electromagnetic radiation having the fourth wavelength spectrum.

9. Optoelectronic device according to one of the preceding claims 7 or 8,
in which the second filter layer (7) is formed at least partially to reflect the electromagnetic radiation having the fourth wavelength spectrum.

10. Optoelectronic device according to the preceding claim, having an encapsulation disposed upstream or disposed downstream of the structured layer (2) in the beam path of the electromagnetic radiation (15) emitted by the organic layer sequence (1).

11. Optoelectronic device according to the preceding claim,
in which the encapsulation is formed as a thin-film encapsulation.

12. Optoelectronic device according to one of the preceding claims,
wherein the electromagnetic radiation which is emitted by the optoelectronic device and perceived by an observer corresponds to a superimposition of the electromagnetic radiation (15) having the first wavelength spectrum and the electromagnetic radiation (16) having the second wavelength spectrum.

13. The optoelectronic device as claimed in any of the preceding claims,
in which the structured layer (2) has striped or crossed-striped or circular or triangular or rectangular regions or a combination of the regions mentioned.

## Revendications

1. Composant optoélectronique comportant
- une succession de couches organique (1), qui émet en fonctionnement un rayonnement électromagnétique (15) avec un premier spectre de longueurs d'onde ;
- une couche structurée (2), qui est disposée en aval de la succession de couches organique (1) dans la trajectoire de faisceau du rayonnement électromagnétique (15) émis par la succession de couches organique (1) et présente une première et une seconde zone (2A, 2B) ; dans laquelle
- les premières zones (2A) présentent respectivement une couche de conversion de longueur d'ondes (3), qui est configurée pour convertir au moins partiellement du rayonnement électromagnétique avec le spectre de longueurs d'ondes en un rayonnement électromagnétique (16) avec un second spectre de longueurs d'ondes ; et
- les secondes zones (2B) présentent respectivement une couche filtrante (4), qui est au moins partiellement opaque pour un rayonnement électromagnétique avec un troisième spectre de longueurs d'onde, qui correspond au moins à une partie du deuxième spectre de longueurs d'onde, dans laquelleles premières et secondes zones (2A, 2B) de la couche structurée (2) sont disposées latéralement dans la trajectoire de faisceau du composant optoélectronique;
**caractérisé en ce que** la couche filtrante (4) et transparente pour le rayonnement électromagnétique (15) sur de l'ensemble de la zone du spectre de longueur d'ondes sur de laquelle la succession de couches organique (1) émet.

2. Composant optoélectronique selon la revendication précédente,
dans laquelle le premier spectre de longueur d'ondes comporte une zone de longueur d'ondes bleue et le second spectre de longueur d'ondes comporte une zone de longueur d'ondes jaune, dans laquelle le composant optoélectronique à l'état désactivé éveille en un observateur une impression de couleur non

3. Composant optoélectronique selon une quelconque des revendications précédentes,
dans laquelle la couche filtrante (4) est configurée afin de convertir le rayonnement électromagnétique avec le troisième spectre de longueurs d'onde en un rayonnement électromagnétique à partir d'une zone de longueur d'ondes non visible.

4. Composant optoélectronique selon la revendication précédente,
dans laquelle la couche filtrante (4) est configurée afin d'absorber le rayonnement électromagnétique avec le troisième spectre de longueur d'ondes.

5. Composant optoélectronique selon une quelconque des revendications précédentes,
comportant une seconde couche de conversion de longueur d'ondes (6), qui est positionnée en aval des premières zones (2A) et/ou des secondes zones (2B) dans la trajectoire de faisceau du rayonnement électromagnétique (15) émis par la succession de couches organique (1) et est configurée afin de convertir au moins partiellement du rayonnement électromagnétique à partir d'une plage de longueurs d'onde, qui se trouve au-dessous d'une plage de longueurs d'ondes (15) du premier spectre de longueur d'ondes en un rayonnement électromagnétique à partir de la plage de longueurs d'onde du premier spectre de longueurs d'onde.

6. Composant optoélectronique selon la revendication précédente,
dans laquelle la seconde couche de conversion de longueurs d'onde (6) est configurée afin de convertir du rayonnement électromagnétique à partir d'une plage de longueurs d'onde ultraviolette en un rayonnement électromagnétique à partir d'une plage de longueurs d'onde bleue.

7. Composant optoélectronique selon une quelconque des revendications précédentes,
dans laquelle les premières zones (2A) présentent respectivement une seconde couche filtrante (7), qui est positionnée en aval de la couche de conversion de longueur d'ondes (3) dans la trajectoire de faisceau du rayonnement électromagnétique (15) émis par la succession de couches organique (1) et qui est imperméable au moins partiellement pour un rayonnement électromagnétique avec un quatrième spectre de longueurs d'onde qui correspond au moins à une partie du premier spectre de longueurs d'onde.

8. Composant optoélectronique selon la revendication précédente,
dans laquelle la seconde couche filtrante (7) est configurée afin d'absorber au moins partiellement le rayonnement électromagnétique avec le quatrième spectre de longueur d'ondes.

9. Composant optoélectronique selon une quelconque des revendications 7 ou 8,
dans laquelle la seconde couche filtrante (7) est configurée afin de réfléchir au moins partiellement le rayonnement électromagnétique avec le quatrième spectre de longueur d'ondes.

10. Composant optoélectronique selon la revendication précédente, comportant une encapsulation qui est disposé en amont ou en aval de la couche structurée (2) dans la trajectoire de faisceau du rayonnement électromagnétique (15) émis par la succession de couches organique (1).

11. Composant optoélectronique selon la revendication précédente,
dans laquelle l'encapsulation est réalisé comme une encapsulation en couche fine.

12. Composant optoélectronique selon une quelconque des revendications précédentes,
dans laquelle le rayonnement électromagnétique perçu par un observateur et émis par le composant optoélectronique correspond à une superposition du rayonnement électromagnétique (15) avec le premier spectre de longueurs d'onde et du rayonnement électromagnétique (16) avec le second spectre de longueurs d'onde.

13. Composant optoélectronique selon une quelconque des revendications précédentes,
dans laquelle la couche structurée (2) présente des zones à rayures, ou à rayures croisées, ou à motifs circulaires ou triangulaires, ou rectangulaires, ou une combinaison desdites zones.
